Europäisches Patentamt

European Patent Office

Office européen des brevets

(19)

(11) Veröffentlichungsnummer : **0 389 577 B1**

(12) **EUROPÄISCHE PATENTSCHRIFT**

(45) Veröffentlichungstag der Patentschrift :
**15.09.93 Patentblatt 93/37**

(21) Anmeldenummer : **89908152.5**

(22) Anmeldetag : **15.07.89**

(86) Internationale Anmeldenummer :
**PCT/DE89/00470**

(87) Internationale Veröffentlichungsnummer :
**WO 90/02451 08.03.90 Gazette 90/06**

(51) Int. Cl.⁵ : **H03K 19/21, G06G 7/163**

(54) **SCHALTUNGSNORDNUNG ZUR AUSSCHLIESSENDEN ODER-VERKNÜPFUNG ZWEIER SIGNALE.**

(30) Priorität : **27.08.88 DE 3829164**

(43) Veröffentlichungstag der Anmeldung :
**03.10.90 Patentblatt 90/40**

(45) Bekanntmachung des Hinweises auf die
Patenterteilung :
**15.09.93 Patentblatt 93/37**

(84) Benannte Vertragsstaaten :
**FR GB IT SE**

(56) Entgegenhaltungen :
**US-A- 4 408 134
Elektronik, Band 36, Nr. 19, 18. September
1978, (München, DE), I. Martiny:
"Grundschaltungen für digitale, bipolare
Hochgeschwindigkeits-ICs", Seiten 140-146**

(73) Patentinhaber : **ANT Nachrichtentechnik
GmbH
Gerberstrasse 33
D-71522 Backnang (DE)**

(72) Erfinder : **SCHMIDT, Lothar
Marktstrasse 398
D-4630 Bochum 1 (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Schaltungsanordnung zur ausschließenden Oder-Verknüpfung zweier Signale

Die Erfindung betrifft eine Schaltungsanordnung zur ausschließenden Oder-Verknüpfung zweier Signale gemäß Oberbegriff des Patentanspruches 1.

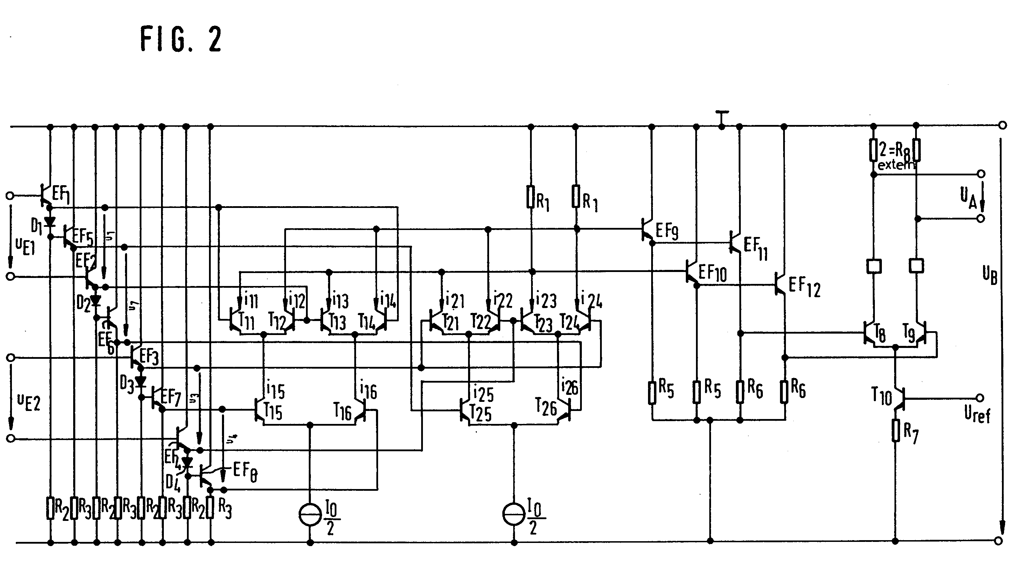

Durch die US-A-4,408,134 ist ein EXOR-Gatter in ECL-Technik bekannt geworden, bei dem die beiden Eingänge A und B mit den Basisanschlüssen von jeweils einem Stromschaltertransistor von übereinander angeordneten Stromschalterpaaren verbunden sind (21, 24 u. 25; Figur 2). Die Basen der jeweils anderen Stromschaltertransistoren (22, 23 u. 26) sind mit den internen Referenzspannungsquellen ($V_{BB1}$ bzw. $V_{BB2}$) verbunden. Die Kollektorströme der Transistoren 21 u. 23 fließen durch den gemeinsamen Lastwiderstand 28, an dem ein Spannungssignal abfällt, welches die ausschließende Oder-Verknüpfung der an den Eingängen A u. B anliegenden Signale darstellt. Dieses Ausgangssignal gelangt über den Emitterfolger 27 an den Ausgangsknoten 17 des EXOR-Gatters.

Durch den Aufsatz "Grundschaltungen für digitale, bipolare Hochgeschwindigkeits-ICs" von I. Martiny in Elektronik Band 36, Nr. 19, 18. Sept. 1987, Seiten 140-146, ist ein EXOR-Gatter in DECL-Technik beschrieben, dessen Grundstruktur aus der analogen Signalverarbeitung bekannt ist und wobei Inverter mit Stromquellen- und Referenzspannungsgegenkopplungen, mit Eingangspaaren, an denen jeweils 2 zueinander logisch komplementäre Signale anstehen, und mit Emitterfolgern zur Potentialverschiebung verwendet werden.

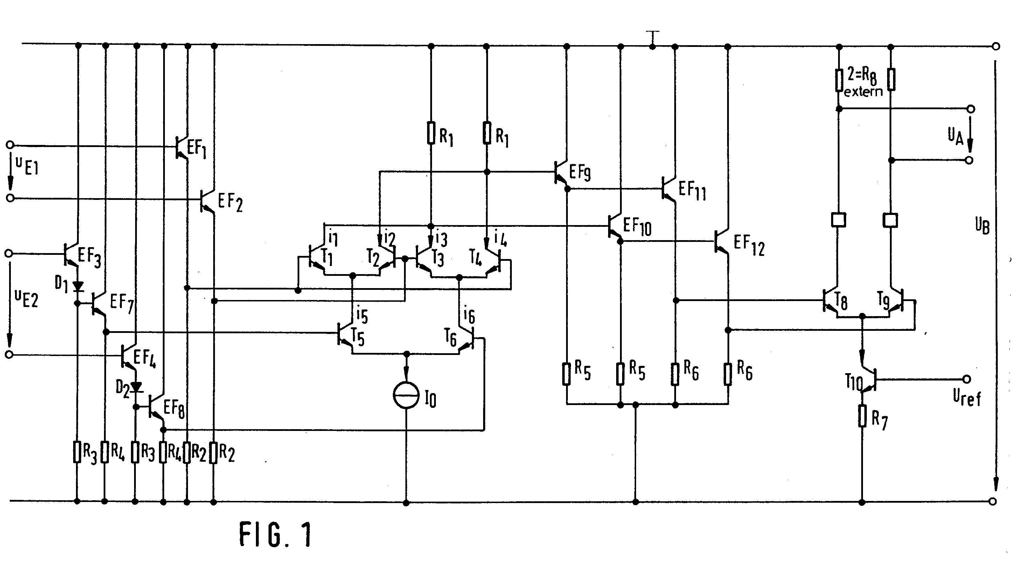

Eine verbesserte Schaltungsanordnung zur ausschließenden Oder-Verknüpfung zweier Signale ist in Figur 1 dargestellt. Diese Anordnung ist in Emitter-Emitter-Coupled-Logic ($E^2CL$-) Technik ausgeführt. Aber auch diese verbesserte Anordnung weist noch einige Nachteile auf. Um diese Nachteile im folgenden verdeutlichen zu können, wird kurz auf die Aufgabe der einzelnen Funktionsblöcke eingegangen.

Eine erste Eingangsstufe für das Eingangssignal $U_{E1}$ besteht aus den Eingangstransistoren $EF_1$ und $EF_2$ in Emitter-Schaltung. Eine zweite Eingangsstufe für das Eingangssignal $U_{E2}$ besteht aus den beiden Eingangstransistoren $EF_3$ und $EF_4$ jeweils in Emitter-Schaltung, denen jeweils mittels einer Diode $D_1$ bzw. $D_2$ ein Emitterfolger $EF_7$ bzw. $EF_8$ nachgeschaltet sind. Die Eingangsstufen dienen sowohl der Pegelanpassung auch der Entkopplung des eigentlichen EXOR-Gatters von der ansteuernden Schaltung. Die Transistoren der Eingangsstufen sind jeweils mit ihren Kollektoren an Masse und über ihre Emitterwiderstände $R_2$, $R_3$ und $R_4$ an den Minuspol einer Betriebsspannungsquelle $U_B$ angeschaltet. Das eigentliche EXOR-Gatter besteht aus Stromschaltern, die übereinander angeordnet sind (Series Gating). Durch diese serielle Hintereinanderschaltung ist eine Pegelverschiebung zwischen den beiden Eingangssignalen des eigentlichen EXOR-Gatters notwendig. Dies wird durch das Diodenpaar $D_1$, $D_2$ und das Emitterfolgerpaar $EF_7$ bzw. $EF_8$ erreicht. Die Potentialdifferenz zwischen den beiden internen Signalebenen beträgt somit im Beispiel 2 x Basisemitterspannung.

Zur Logischen Verknüpfungen der beiden Eingangssignale dienen die genannten Stromschalter mit den Transistoren $T_1$ bis $T_6$. Das untere Stromschalterpaar mit den Transistoren $T_5$ und $T_6$ ist emittergekoppelt und über eine Stromquelle $I_0$ mit dem Minuspol der Betriebsspannungsquelle $U_B$ verbunden. Seine Basiseingänge werden von den Ausgängen der Emitterfolger $EF_7$ bzw. $EF_8$ angesteuert. An den beiden Kollektorausgängen $i_5$ und $i_6$ sind nun jeweils ein oberes Paar von weiteren Stromschaltern angeschaltet. Das erste Paar dieser jeweils ebenfalls emittergekoppelten Transistorpaare besteht aus den Transistoren $T_1$, $T_2$ bzw. $T_3$ und $T_4$. Die beiden Basiseingänge des ersten Paares $T_1$, $T_2$ werden von den Emitterausgängen der ersten Eingangsstufe $EF_1$ bzw. $EF_2$ angesteuert, während die Basiseingänge des zweiten Paares $T_3$ und $T_4$ invers dazu von den Emitterausgängen derselben genannten Eingangsstufe angesteuert werden. Die vier Kollektorausgänge der beiden oberen Stromschalterpaare sind paarweise parallelgeschaltet, $i_1$ mit $i_3$ und $i_2$ mit $i_4$, und jeweils über Lastwiderstände $R_1$ mit Massepotential (Pluspotential) der Betriebsspannungsquelle $U_B$ verbunden. Das Differenzausgangssignal ist an diesen Lastwiderständen $R_1$ abnehmbar. Zur Regeneration der Signalpegel sowie zur Entkopplung des eigentlichen EXOR-Gatters vom Ausgang dient eine nachgeschaltete Bufferstufe, die im Beispiel aus zwei Emitterfolgerpaaren $EF_9$, $EF_{11}$; $EF_{10}$, $EF_{12}$ mit den Emitterwiderständen $R_5$, $R_5$; $R_5$, $R_5$ mit dem Minuspol der Betriebsspannungsquelle verbunden sind, und einem Stromschalter mit den ebenfalls emittergekoppelten Transistoren $T_8$, $T_9$, deren gemeinsamer Emitter über eine Steuerspannung $U_{ref}$ steuerbare Stromquelle aus der Reihenschaltung eines Transistors $T_{10}$ und ein Widerstand $R_7$ mit dem Minuspol der Betriebsspannungsquelle verbunden ist, und dessen beiden Kollektorausgänge mit externen Lastwiderständen 2 x $R_8$ mit Massepotential verbunden sind, besteht.

Wechselt an einem Eingang des EXOR-Gatters der Signalpegel, während der Pegel am anderen Eingang konstant bleibt, so ändert sich die Spannung am Ausgang des EXOR-Gatters. Werden beide Eingangspegel gleichzeitig umgeschaltet, so wird bei einer idealen EXOR-Verknüpfung das Ausgangssignal nicht beeinflußt. Weil jedoch während des Umschaltens die Differenzspannung an den Stromschaltereingängen beider Signalebenen kurzzeitig den Wert 0 Volt annimmt, fließt der Strom $I_0$ in diesem Moment zu gleichen Teilen durch die beiden Lastwiderstände $R_1$.

Hierdurch vermindert sich der Betrag der EXOR-Ausgangsspannung, bevor sich wieder der ursprüngliche positive oder negative Maximalwert der Ausgangsspannung einstellt. Im ungünstigsten Fall bricht die Differenzausgangsspannung auf 0 Volt zusammen.

Die Nachteile des EXOR-Gatters zeigen sich bei folgenden verschiedenen Anwendungen.

1. Frequenzabhängige Laufzeitdifferenz zwischen den Signalebenen.

Die logische Verknüpfung der Eingangssignalen findet in den Transistoren $T_1$ bis $T_4$ statt. Der Signalfluß dorthin erfolgt auf 2 unterschiedlichen Wegen. Während das eine Eingangssignal über den Emitterfolger $EF_1$ an die Basen von $T_1$ und $T_4$ bzw. über $EF_2$ an die Basen von $T_2$ und $T_3$ gelangt, fließt das andere Eingangssignal über $EF_3/D_1/EF_7$ und $T_5$ zu den Emittern von $T_1/T_2$ bzw. über $EF_4/D_2/EF_8$ und $T_6$ zu den Emittern von $T_3/T_4$. Aufgrund der endlichen Schaltgeschwindigkeit der Transistoren wird die Laufzeit in den verschiedenen Signalwegen unterschiedlich.

Dadurch entsteht zwischen den zu verknüpfenden Signalen eine Laufzeitdifferenz $t_L$, die sich bei den unterschiedlichen Anwendungsmöglichkeiten des EXOR-Gatters wie folgt auswirkt:

1.1 Zur Frequenzverdoppelung werden an die beiden Eingänge des EXOR-Gatters periodische Signale gelegt, die lediglich eine geeignete Phasendifferenz aufweisen, z. B.:

$$U_{E1} = U_1 . \sin \omega t$$
$$U_{E2} = U_1 . \sin \left| \omega t - \phi \right|.$$

Die durch die unterschiedlichen Signalwege im EXOR-Gatter entstehende Laufzeitdifferenz der Eingangssignale läßt sich durch einen zusätzlichen Phasenwinkel $\zeta$ zwischen den Eingangssignalen beschreiben, wenn man das EXOR-Gatter im Bezug auf Laufzeitunterschiede als ideal betrachten möchte. Da die Laufzeitdifferenz indes auch eine Funktion der Kreisfrequenz ist, gilt $\zeta = f(\omega)$.

Das EXOR-Gatter verhält sich bei der Frequenzverdoppelung dann ideal, wenn gilt

$$\phi - \zeta(\omega) = (2n - 1) \cdot \pi/2$$

Nur in diesem Fall ist das Ausgangssignal des EXOR-Gatters gleichspannungsfrei, so daß das gewünschte Tastverhältnis von 1:1 auftritt. Zur optimalen Funktion des Gatters als Frequenzverdoppler ist also eine von der Betriebsfrequenz abhängige Einstellung des Phasenwinkels $\phi$ zwischen den Eingangssignalen erforderlich. Dies ist insbesondere dann aber kaum möglich, wenn die ansteuernden Schaltungen monolytisch mit integriert werden.

1.2 Differenzieren und Gleichrichten.

Beim Differenzieren und Gleichrichten wird eine beliebige Bitfolge direkt auf den einen EXOR-Eingang und die gleiche Bitfolge verzögert auf den anderen EXOR-Eingang gelegt. Der Ausgangssignalpegel ändert sich dadurch bei jeder Flanke des Eingangssignals, wodurch eine Taktrückgewinnung aus der Bitfolge möglich ist. Bei dieser Anwendung weist das beschriebene EXOR-Gatter folgende Nachteile auf. Die ansteigende und die abfallende Flanke des Ausgangssignals haben unterschiedliche Flankensteilheiten, da die Signalwege zu oberen und zur unteren Stromschalterebene unterschiedliches Tiefpaßverhalten aufweisen. Die Kurvenform des Ausgangssignals kann also unsymmetrisch werden und hängt davon ab, welche Signalebene direkt und welche verzögert angesteuert wird.

1.3 Anwendung als Phasendetektor

Steuert man das EXOR-Gatter wie unter 1.1 an, so ist die Ausgangsgleichspannung ein Maß für die Phasenverschiebung zwischen den beiden Eingangstaktsignalen:

$$U_A - = U_{A,0} . \cos. \left| \phi - \zeta(\omega) \right|.$$

Die maximale Empfindlichkeit die $u_{A^-}/d\phi$ tritt für $\phi = \pi/2 + \zeta(\omega)$ auf. Dieser Symmetriepunkt der Funktion $u_{A^-} = f(\omega)$ ist wegen der frequenzabhängigen Differenzlaufzeit ebenfalls frequenzabhängig.

1.4 Logische Verknüpfung von Bitfolgen.

Legt man an die beiden EXOR-Eingänge beliebige Bitfolgen, so darf die EXOR-Ausgangsspannung ihren Pegel jeweils dann ändern, wenn sich nur eine der beiden Eingangsspannungen ändert. Die bereits im Abschnitt 1 definierte Laufzeitdifferenz $\Delta t_L$ zwischen den verschiedenen Signalwegen führt zu einem entsprechenden Jitter des Ausgangssignals, der wegen der Frequenzabhängigkeit nicht breitbandig kompensierbar ist.

Wie in Abschnitt 1.2 besprochen, kann darüberhinaus die Flankensteilheit des Ausgangssignals davon abhängig sein, in welcher Stromschalteebene die Umschaltung erfolgt.

2. Eingangsimpedanz

Aufgrund der Schaltungsunsymmetrie haben die beiden EXOR-Eingänge unterschiedliche Eingangs-Impedanzen. Dadurch bedingt werden die Eingangs-Signalquellen unterschiedlich stark belastet. Außerdem unterscheiden sich die Reflektionsfaktoren der beiden Eingänge.

Der Erfindung lag deshalb die Aufgabe zugrunde, eine Schaltungsanordnung der eingangs genannten Art anzugeben, die in der Lage ist die geschilderten Nachteile zu eliminieren. Der Aufwand hierzu soll nicht allzu hoch sein.

Die Lösung dieser Aufgabe erfolgt durch die Merkmale des Patentanspruches 1.

Das erfindungsgemäße ausschließende Oder-Gatter weist die Vorteile auf, daß beide Eingangsstufen dieselben Eingangsimpedanzen haben, daß gleiche Schalt- und Signallaufzeiten auftreten.

Der Erfindung lag die grundlegende Idee zugrunde, das eingangs genannte EXOR-Gatter vollkommen symmetrisch aufzubauen. Im einzelnen werden dabei die Eingangsstufen des erfindungsgemäßen EXOR-Gatters so ausgelegt, daß beide Eingangssignale sowohl auf eine obere als auch mit verschobenen Pegeln auf eine untere Stromschalterebene gelegt werden; dadurch wird gewährleistet, daß beide Eingänge dieselbe Eingangsimpedanz aufweisen. Zum anderen wird die obere Stufe des EXOR-Gatters, in der die logische Verknüpfung erfolgt, zweifach ausgeführt. Durch die doppelte Ausführung der Verknüpfungsstufen wird es ermöglicht, daß bei jedem Pegelwechsel an einem EXOR-Eingang immer sowohl eine obere als auch eine untere Stromschalterebene umgeschaltet wird. Dadurch werden gleiche Schalt- und Signallaufzeiten erreicht, unabhängig davon, an welchem Eingang ein Pegelwechsel erfolgt.

Die abhängigen Ansprüche stellen vorteilhafte Ausgestaltungen der Erfindung dar.

Es erfolgt nun die Beschreibung anhand der Figur 2, welche das vollständige Schaltbild für ein Ausführungsbeispiel des erfindungsgemäßen EXOR-Gatters beinhaltet.

Erkennbar sind die Bestandteile des EXOR-Gatters gemäß Figur 1, wobei alle Bezeichnungen, auch für die darüberhinaus gleichgebliebenden Teile der Figur 1, beibehalten sind.

Erfindungsgemäß ist auch die obere Eingangsstufe für das erste Eingangssignal $u_{E1}$ hinter den Eingangstransistoren $EF_1$ und $EF_2$ mit nachfolgenden Emitterfolgern $EF_5$ und $EF_6$ versehen, welche über Dioden $D_1$ und $D_2$ angekoppelt sind. Die Emitterwiderstände sind für die Eingangstransistoren mit $R_2$ bzw. für die Emitterfolger mit $R_3$ jeweils gleich. Durch diesen Aufbau sind die Eingangsstufen symmetrisch und bieten damit gleiche Eingangsimpedanzen. Zu dem eigentlichen EXOR-Gatter ist ein zweites gleichartig aufgebautes Gatter vorgesehen, wobei die beiden Ausgänge parallel geschaltet sind. Die Ansteuerung dieser zweiten Stromschaltergruppe erfolgt in der gleichen Weise wie die der ersten Gruppe, indem nunmehr zusätzlich das untere Stromschalterpaar $T_{25}$ und $T_{26}$ des zweiten EXOR-Gatters von den beiden Ausgängen der zusätzlich vorgesehenen Emitterfolger der oberen Eingangsstufe $EF_5$ bzw. $EF_6$ angesteuert werden. In entsprechender Weise werden die Basiseingänge der beiden oberen Stromschalterpaare $T_{21}$, $T_{22}$ bzw. $T_{23}$, $T_{24}$ des zweiten EXOR-Gatters von den Emitter-Ausgängen der Eingangstransistoren $EF_3$ bzw. $EF_4$ der unteren Eingangsstufe angesteuert.

Gemäß dem Realisierungsbeispiel nach Figur 2 sind die Lastwiderstände $R_1$ für beide Verknüpfungsstufen dieselben, und die speisenden Stromquellen sind in entsprechender Weise jeweils für den halber Strom $i_0/2$ ausgelegt.

Der Ausgangsbuffer entspricht in Aufbau und Funktion dem Ausgangsbuffer des EXOR-Gatters nach Figur 1.

Die Vorteile des erfindungsgemäßen EXOR-Gatters im Einzelnen:

1. Einsatz des EXOR-Gatters als Frequenzverdoppler.

Beim Einsatz des EXOR-Gatters als Frequenzverdoppler (Eingangsspannungen $u_{E1}$ und $u_{E2}$ laut Definition in Abschnitt 1.1) erhält man eine Ausgangsspannung, die im Idealfall gleichspannungsfrei ist und deren Tastverhältnis 1:1 ist.

Berücksichtigt man den durch die unterschiedlichen Signalwege zu den oberen und unteren Stromschalterebenen hervorgerufenen Laufzeitunterschied zwischen den Eingangssignalen durch einen zusätzlichen Phasenwinkel , so läßt sich beim Einsatz des Doppel-EXOR-Gatter als Frequenzverdoppler für die Ausgangsgleichspannung $u_{A=}$, folgender Zusammenhang herleiten (vgl. Diplomarbeit L. Schmidt):

$$u_{A=} = U_{A,0} \cdot \cos\phi \cos |\zeta(\omega)| \quad (2)$$

Für $\phi = (2n-1) \cdot \pi/2$ (n=0, ±1,±2..) wird das Ausgangssignal gleichspannungsfrei unabhängig von der Kreisfrequenz !

2. Differenzieren und Gleichrichten

Bei Verwendung des EXOR-Gatters zum Differenzieren und Gleichrichten einer beliebigen Bitfolge entfallen die oben beschriebenen Nachteile des EXOR-Gatters.

Die ansteigende und die abfallende Flanke besitzen hier die gleiche Flankensteilheit, weil bei jedem Schaltvorgang sowohl eine untere als auch eine obere Stromschalterebene umgeschaltet werden, d. h. die RC-Zeitkonstanten sowie die Transistorschaltzeiten beider Signalwege beeinflussen in gleicher Weise beide Flanken des Ausgangssignals.

Hieraus folgt auch, daß das Ausgangssignal gleiche Flankensteilheiten besitzt und daß die Kurvenform des Ausgangssignals unabhängig davon ist, welcher der beiden Doppel-EXOR-Eingänge direkt und welcher verzögert angesteuert wird.

3. Anwendung des EXOR-Gatters als Phasendetektor Steuert man das EXOR-Gatter so mit einem periodischen Signal an, daß zwischen den sonst gleichen EXOR-Eingangsspannungen lediglich eine Phasenverschiebung besteht, so ergibt sich für den Gleichspannungsanteil $u_{A=}$ des Ausgangssignals der in Gleichung (2) angegebenen Wert. Die maximale Empfindlichkeit $du_{A=}/d\phi$, die bei $\nabla = \pi/2$ auftritt, ist zwar um den Faktor $\cos |\zeta(\omega)|$ geringer als beim Standard-EXOR-Gatter jedoch im Gegensatz zu diesem frequenzunabhängig. Somit ist auch der Symmetriepunkt der Funktion $u_{A=} = f(\phi)$ frequenzunabhängig.

4. Logische Verknüpfung von Bitfolgen

Da beim EXOR-Gatter immer sowohl eine obere als auch eine untere Stromschalterebene umschaltet, unabhängig davon welcher der beiden Eingangs-Spannungspegel wechselt, ist die Signallaufzeit zwischen dem Empfang und dem Ausgang konstant.

Die frequenzabhängige Laufzeitdifferenz zwischen den Signalen an den oberen und den unteren Stromschalterebenen der Verknüpfungsstufen führt hier also nicht zu einem Jitter des Ausgangssignals.

Die Flankensteilheit des Ausgangssignals ist beim völlig symmetrischen EXOR-Eingang immer gleich, unabhängig davon, an welchem EXOR-Eingang ein Pegelwechsel erfolgt. Sie ist allerdings etwas geringer als beim Standard-EXOR.

Das erfindungsgemäße Gatter erweist sich also bei allen o.g. typischen EXOR-Anwendungen als vorteilhaft gegenüber dem EXOR-Gatter nach Figur 1.

Der Mehraufwand an Schaltelementen stellt bei der monolithischen Integration demgegenüber keinen wesentlichen Nachteil der.

Die im vorigen Abschnitt 4. erwähnte etwas geringere Flankensteilheit kann am Ausgang der Verknüpfungsstufe durch eine zusätzliche Versteilerungsstufe ausgeglichen werden.

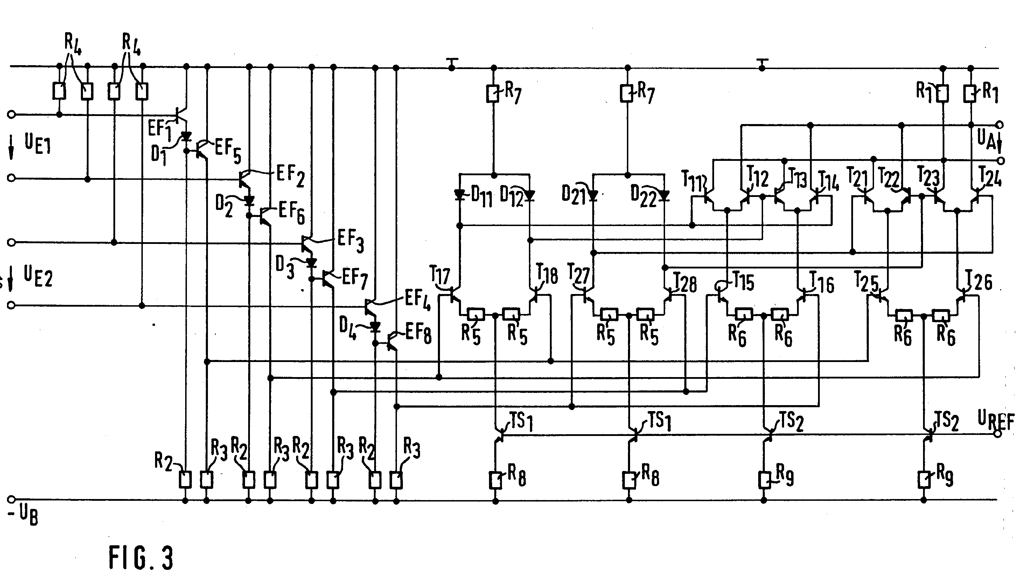

5. Anwendung des EXOR-Gatters als Multiplizierer Das erfindungsgemäße EXOR-Gatter läßt sich mit geringen Änderungen vorteilhaft auch als analoger Multiplizierer verwenden. Diese Änderungen sind in Figur 3 dargestellt, welche im Prinzip die Schaltungsanordnung nach Figur 2 zeigt, ergänzt um einige weitere Bauteile.

Wenn zwei Ergänzungen des Schaltungskonzepts nach Figur 2 vorgenommen werden, liegt mit der Schaltung ein analoger Multiplizierer mit großem Dynamikbereich der Eingangsspannungen vor. Diese beiden Ergänzungen sind folgende:

Zum einen wird die Schaltungsanordnung zur Erhöhung des Linearitätsbereichs der Stromschalter in der oberen Ebene, das sind die Transistoren $T_{11}$ bis $T_{14}$ sowie $T_{21}$ bis $T_{24}$ um zwei Vorverzerrerstufen erweitert.

Zum andern werden in die beiden Stromschalter der unteren Stromschalterebene der Stromschaltergruppen, das sind die Transistoren $T_{15}$, $T_{16}$ und $T_{25}$, $T_{26}$, Gegenkopplungswiderstände $R_6$ zur Erhöhung des Linearitätsbereichs eingefügt. Diese Maßnahme wird auch bei den Vorverzerrern eingeführt, nämlich mit den Gegenkopplungswiderständen $R_5$ bei den Transistoren $T_{17}$, $T_{18}$ der ersten Vorverzerrerstufe und den Transistoren $T_{27}$,

$T_{28}$ der zweiten Vorverzerrerstufe. Die Emitter der beiden Stromschalterpaare der Vorverzerrerstufen sind jeweils über diese Gegenkopplungswiderstände $R_5$ mit den Stromquellen, bestehend aus $TS_1$ und deren Emitterwiderstände $R_8$ verbunden. Die Kollektoren der genannten Stromschaltertransistoren sind über die Diodenpaare $D_{11}$, $D_{12}$ bzw. $D_{21}$, $D_{22}$ und die Pegelverschiebungswiderstände $R_7$ mit dem Pluspol, Masse, der Betriebsspannungsquelle verbunden. An den Verbindungspunkten zwischen den Dioden und ihren Kollektoren werden die zur Ansteuerung der oberen Stromschalterebene benötigten Signale abgegriffen, wobei also die Basen der Transistorpaare der oberen Stromschalterebene jeweils kreuzweise miteinander und mit dem zugehörigen Kollektor der entsprechenden Vorverzerrerstufe verbunden sind. Die ansteuernden Signale für die Vorverzerrerstufen werden ebenso wie die ansteuernden Signale der unteren Stromschalterebene hinter den Emitterfolgerpaaren $EF_5$ und $EF_6$ bzw. $EF_7$, $EF_8$ abgenommen. Die Abgriffe hinter den Emitterfolgerpaaren $EF_1$, $EF_2$ sowie $EF_3$, $EF_4$, die beim Doppel-EXOR-Gatter gemäß Figur 2 zur Ansteuerung der oberen Stromschalter erforderlich sind, entfallen hier.

Die Vorteile des Doppel-EXOR-Gatters gelten im selben Maße auch für den Multiplizierer.

Die gegenüber bekannten Multipliziererkonzepten erhöhte Zahl der benötigten Transistoren stellt bei der monolithischen Integration keinen wesentlichen Nachteil dar.

## Patentansprüche

1. Schaltungsanordnung zur ausschließenden Oder-Verknüpfung zweier Signale, mit einer Gruppe von seriell angeordneten, von einer mit dem einen Pol der Betriebsspannungsquelle verbundenen Stromquelle gespeisten Stromschaltern, mit jeweils einer von der Betriebsspannungsquelle gespeisten Transistoreingangsstufe für das erste ($U_{E1}$) und das zweite ($U_{E2}$) Eingangssignal, wobei jede Transistoreingangsstufe über einen ersten und einen zweiten Eingang, zwischen welchen das jeweilige Eingangssignal ($U_{E1}$; $U_{E2}$) anliegt, verfügt und an ihren beiden Eingängen erste Emitterfolger ($EF_1$, $EF_2$; $EF_3$, $EF_4$) zur Pegelanpassung und Entkopplung aufweist, wobei zur Pegelverschiebung des zweiten Eingangssignales ($U_{E2}$) den in der Transistoreingangsstufe für das zweite Eingangssignal ($U_{E2}$) vorgesehenen ersten Emitterfolgern ($EF_3$; $EF_4$) jeweils über eine Diode ($D_3$; $D_4$) gekoppelte zweite Emitterfolger ($EF_7$; $EF_8$) nachgeschaltet sind, deren Ausgänge zwei erste emittergekoppelte im Gegentakt arbeitende, von der Stromquelle ge-

speiste Transistor-Stromschalter ($T_{15}$, $T_{16}$) an ihren Basiseingängen ansteuern und wobei die Ausgänge der in der Transistoreingangsstufe für das erste Eingangssignal ($U_{E1}$) vorgesehenen ersten Emitterfolger ($EF_1$; $EF_2$) jeweils zwei zweite ($T_{11}$, $T_{12}$) und zwei dritte ($T_{13}$, $T_{14}$) jeweils paarweise emittergekoppelte und im Gegentakt arbeitende, seriell in den Kollektorpfad der ersten Transistorschalter ($T_{15}$, $T_{16}$) geschaltete Transistor-Stromschalter an ihren Basiseingängen ansteuern, wobei jeweils die Kollektoren des einen zweiten ($T_{11}$) und des einen dritten ($T_{13}$) Stromschalters und die Kollektoren des anderen zweiten ($T_{12}$) und des anderen dritten ($T_{14}$) Stromschalters zusammengeschaltet sind, wobei der eine zweite ($T_{11}$) und der andere dritte ($T_{14}$) Stromschalter vom Signal am ersten Eingang der Transistoreingangsstufe für das erste Eingangssignal ($U_{E1}$), über den jeweiligen Emitterfolger, angesteuert werden und der andere zweite ($T_{12}$) und der eine dritte ($T_{13}$) Stromschalter vom Signal am zweiten Eingang der Transistoreingangsstufe für das erste Eingangssignal ($U_{E1}$), über den jeweiligen Emitterfolger, angesteuert werden, und wobei die beiden zusammengeschalteten Kollektorpaare der zweiten ($T_{11}$, $T_{12}$) und dritten ($T_{13}$, $T_{14}$) Stromschalter jeweils über einen gleich großen Lastwiderstand ($R_1$) mit dem anderen Pol der Betriebsspannungsquelle verbunden sind und aus der Spannungsdifferenz zwischen den beiden zusammengeschalteten Kollektorpaaren das Differenzausgangssignal ($U_A$) der Schaltungsanordnung gewonnen wird,
dadurch gekennzeichnet,
daß den in der Transistoreingangsstufe für das erste Eingangssignal ($U_{E1}$) vorgesehenen ersten Emitterfolgern ($EF_1$; $EF_2$) zur Verschiebung des Pegels des ersten Eingangssignales ($U_{E1}$) jeweils über eine Diode ($D_1$; $D_2$) gekoppelte zweite Emitterfolger ($EF_5$; $EF_6$) nachgeschaltet sind, deren Ausgänge zwei vierte emittergekoppelte, im Gegentakt arbeitende, von der Stromquelle gespeiste Transistor-Stromschalter ($T_{25}$, $T_{26}$) an ihren Basiseingängen ansteuern,
daß die Ausgänge der in der Transistoreingangsstufe für das zweite Eingangssignal ($U_{E2}$) vorgesehenen ersten Emitterfolger ($EF_3$; $EF_4$) jeweils zwei fünfte ($T_{21}$, $T_{22}$) und zwei sechste ($T_{23}$, $T_{24}$) jeweils paarweise emittergekoppelte und im Gegentakt arbeitende, seriell in den Kollektorpfad der vierten Transistor-Stromschalter ($T_{25}$, $T_{26}$) geschaltete Transistor-Stromschalter an ihren Basiseingängen ansteuern,
daß jeweils die Kollektoren des einen fünften ($T_{21}$) und des einen sechsten ($T_{23}$) Stromschalters und die Kollektoren des anderen fünften ($T_{22}$) und des anderen sechsten ($T_{24}$) Stromschalters zusammengeschaltet sind, wobei der eine fünfte ($T_{21}$) und der andere sechste ($T_{24}$) Stromschalter vom Signal am ersten Eingang der Transistoreingangsstufe für das zweite Eingangssignal ($U_{E2}$), über den jeweiligen Emitterfolger, angesteuert werden und der andere fünfte ($T_{22}$) und der eine sechste ($T_{23}$) Stromschalter vom Signal am zweiten Eingang der Transistoreingangsstufe für das zweite Eingangssignal ($U_{E2}$), über den jeweiligen Emitterfolger, angesteuert werden, und daß die beiden zusammengeschalteten Kollektorpaare der fünften ($T_{21}$, $T_{22}$) und sechsten ($T_{23}$, $T_{24}$) Stromschalter so mit den beiden zusammengeschalteten Kollektorpaaren der zweiten ($T_{11}$, $T_{12}$) und dritten ($T_{13}$, $T_{14}$) Stromschalter verbunden sind, daß jeweils die Kollektoren der einen zweiten ($T_{11}$), dritten ($T_{13}$), fünften ($T_{21}$) und sechsten ($T_{23}$) Stromschalter und die Kollektoren der anderen zweiten ($T_{12}$), dritten ($T_{14}$), fünften ($T_{22}$) und sechsten ($T_{24}$) Stromschalter miteinander verbunden sind.

2. Schaltungsanordnung nach Anspruch 1, dadurch gekennzeichnet, daß die ersten Emitterfolgerstufen ($EF_1$, $EF_2$; $EF_3$, $EF_4$) der Eingangsstufen jeweils gleiche Emitterwiderstände ($R_2$) aufweisen.

3. Schaltungsanordnung nach Anspruch 1 oder 2, dadurch gekennzeichnet, daß die zweiten Emitterfolgerstufen ($EF_5$, $EF_6$; $EF_7$, $EF_8$) der Eingangsstufen jeweils gleiche Emitterwiderstände ($R_3$) aufweisen.

4. Schaltungsanordnung nach Anspruch 1, 2 oder 3, dadurch gekennzeichnet, daß die eine Gruppe der ersten, zweiten und dritten Stromschalter und die andere Gruppe der vierten, fünften und sechsten Stromschalter jeweils von einer Stromquelle der gleichen Stromstärke ($I_0/2$) gespeist werden.

5. Schaltungsanordnung nach einem der vorhergehenden Ansprüche, dadurch gekennzeichnet, daß zwei Vorverzerrerstufen ($T_{17}$, $T_{18}$; $T_{27}$, $T_{28}$) vorgesehen sind, die jeweils aus zwei im Gegentakt arbeitenden emittergekoppelten Transistoren bestehen und zwischen die Ausgänge der zweiten Emitterfolger ($EF_5$, $EF_6$; $EF_7$, $EF_8$) der Transistoreingangsstufen für das erste ($U_{E1}$) bzw. das zweite ($U_{E2}$) Eingangssignal und die Eingänge der zweiten und dritten bzw. fünften und sechsten Stromschalter ($T_{11}$, $T_{12}$, $T_{13}$, $T_{14}$; $T_{21}$, $T_{22}$, $T_{23}$, $T_{24}$) eingefügt sind, und daß emitterseitig bei den Transistoren der beiden Vorverzerrer ($T_{17}$, $T_{18}$; $T_{27}$, $T_{28}$) und bei den Transistoren ($T_{15}$, $T_{16}$; $T_{25}$, $T_{26}$) der ersten und vierten Stromschalter jeweils Gegenkopplungswiderstände ($R_5$; $R_5$) eingefügt sind.

6. Schaltungsanordnung nach Anspruch 5, dadurch gekennzeichnet, daß die Basen der Emitterfolger (EF$_1$, EF$_2$, EF$_3$, EF$_4$) beider Transistor-Eingangsstufen jeweils über einen Widerstand (R$_4$) mit dem einen Pol (Masse) der Betriebsspannung verbunden sind.

7.  Schaltungsanordnung nach einem der Ansprüche 5 oder 6, dadurch gekennzeichnet, daß die Basen der Transistorpaare (T$_{17}$, T$_{18}$; T$_{27}$, T$_{28}$) der ersten und zweiten Vorverzerrerstufe sowie die Basen der Transistorpaare (T$_{25}$, T$_{26}$; T$_{15}$, T$_{16}$) der vierten und ersten Stromschalter jeweils mit den Emittern der zweiten Emitterfolgerstufe (EF$_5$, EF$_6$; EF$_7$, EF$_8$) der ersten bzw. zweiten Eingangsstufe verbunden sind.

8.  Schaltungsanordnung nach einem der Ansprüche 5 bis 7, dadurch gekennzeichnet, daß die Kollektoren der Transistorpaare der Vorverzerrerstufen jeweils über Entkopplungsdioden (D$_{11}$, D$_{12}$; D$_{21}$, D$_{22}$) und in Serie dazu jeweils paarweise über einen gemeinsamen Kollektorwiderstand (R$_7$; R$_7$) mit dem einen Pol (Masse) der Betriebsspannung verbunden sind.

9.  Schaltungsanordnung nach einem der Ansprüche 5 bis 8, dadurch gekennzeichnet, daß die beiden Vörverzerrerstufen jeweils durch eine Stromquelle (TS$_1$, R$_8$) gespeist werden.

10. Schaltungsanordnung nach einem der Ansprüche 5 bis 9, dadurch gekennzeichnet, daß von der ersten Vorverzerrerstufe der Kollektor des einen Transistors (T$_{17}$) mit den Basen des einen zweiten (T$_{11}$) und des anderen dritten (T$_{14}$) Stromschalters und der Kollektor des anderen Transistors (T$_{18}$) mit den Basen des anderen zweiten (T$_{12}$) und des einen dritten (T$_{13}$) Stromschalters verbunden sind, daß von der zweiten Vorverzerrerstufe der Kollektor des einen Transistors (T$_{27}$) mit den Basen des einen fünften (T$_{21}$) und des anderen sechsten (T$_{24}$) Stromschalters und der Kollektor des anderen Transistors (T$_{28}$) mit den Basen des anderen fünften (T$_{22}$) und des einen sechsten (T$_{23}$) Stromschalters verbunden sind.

11. Schaltungsanordnung nach einem der vorhergehenden Ansprüche, gekennzeichnet durch Ausführung in E$^2$CL-Technik.

**Revendications**

1.  Disposition de circuit de disjonction de deux signaux, comportant un groupe de commutateurs de courant disposés en série et alimentés par une source de courant reliée à l'un des pôles de la source de tension de service, comportant aussi un étage d'entrée à transistor, alimenté par la source de tension de service, pour chacun, du premier (U$_{E1}$) et du second (U$_{E2}$) signaux d'entrée, circuit dans lequel chaque étage d'entrée à transistor dispose d'une première et d'une seconde entrée, entre lesquelles arrive le signal d'entrée respectif (U$_{E1}$; U$_{E2}$) et présente, à ses deux entrées, des premiers transistors à montage émetteur-suiveur (EF$_1$, EF$_2$; EF$_3$, EF$_4$) pour l'accord de niveau et pour le découplage, et circuit dans lequel, pour décaler le niveau du second signal d'entrée (U$_{E2}$), en aval des premiers transistors à montage émetteur-suiveur (EF$_3$; EF$_4$), prévus dans l'étage d'entrée à transistor pour le second signal d'entrée (U$_{E2}$), sont respectivement mis en circuit des seconds transistors à montage émetteur-suiveur (EF$_7$; EF$_8$) qui sont couplés par l'intermédiaire d'une diode (D$_3$; D$_4$) et dont les signaux de sortie pilotent, aux entrées de leur base, deux premiers commutateurs de courant à transistor (T$_{15}$, T$_{16}$) qui sont montés à couplage par l'émetteur, travaillent en opposition de phase et sont alimentés par la source de courant, et circuit dans lequel les signaux de sortie des premiers transistors à montage émetteur-suiveur (EF$_1$, EF$_2$), prévus dans l'étage d'entrée à transistor pour le premier signal d'entrée (U$_{E1}$) pilotent chacun, aux entrées de leur base, deux seconds (T$_{11}$, T$_{12}$) et deux troisièmes (T$_{13}$, T$_{14}$) commutateurs de courant à transistor qui sont respectivement montés par paire à couplage par l'émetteur, travaillent en opposition de phase et sont montés en série sur le chemin du collecteur des premiers commutateurs à transistor (T$_{15}$, T$_{16}$), et circuit dans lequel les collecteurs du premier second (T$_{11}$) et du premier troisième (T$_{13}$) commutateurs de courant et les collecteurs de l'autre second (T$_{12}$) et de l'autre troisième (T$_{14}$) commutateurs de courant sont chacun connectés ensemble, et circuit dans lequel le premier second (T$_{11}$) et l'autre troisième (T$_{14}$) sont pilotés, par l'intermédiaire du transistor à montage émetteur-suiveur respectif, par le signal qui apparait à la première entrée de l'étage d'entrée à transistor pour le premier signal d'entrée (U$_{E1}$) et l'autre second (T$_{12}$) et le premier troisième (T$_{13}$) commutateurs de courant sont pilotés, par l'intermédiaire du transistor à montage émetteur-suiveur respectif, par le signal qui apparait à la seconde entrée de l'étage d'entrée à transistor pour le premier signal d'entrée (U$_{E1}$), et circuit dans lequel les deux paires de collecteurs connectées ensemble des seconds (T$_{11}$, T$_{12}$) et des troisièmes (T$_{13}$, T$_{14}$) commutateurs de courant sont respectivement réunies avec l'autre pôle de la source de tension de service par l'intermédiaire d'une résistance de charge (R$_1$) de même valeur et circuit dans lequel, de la différence de tension entre les deux paires de collecteurs connectées ensemble on déduit le signal différentiel de sortie ($U_A$) de la disposition de circuit,

disposition de circuit caractérisée

par le fait qu'en aval des premiers transistors à montage émetteur-suiveur ($EF_1$; $EF_2$), prévus, dans l'étage d'entrée à transistor pour le premier signal d'entrée ($U_{E1}$), pour le décalage du niveau du premier signal d'entrée ($U_{E1}$), sont mis en circuit des seconds transistors à montage émetteur-suiveur ($EF_5$; $EF_6$) qui sont chacun couplés par l'intermédiaire d'une diode ($D_1$; $D_2$) et dont les signaux de sortie pilotent, aux entrées de leur base, deux quatrièmes commutateurs de courant à transistor ($T_{25}$, $T_{26}$) qui sont montés à couplage par l'émetteur, qui travaillent en opposition de phase et qui sont alimentés par la source de courant,

par le fait que les signaux de sortie des premiers transistors à montage émetteur-suiveur ($EF_3$; $EF_4$), prévus dans l'étage d'entrée à transistor pour le second signal d'entrée ($U_{E2}$), pilotent chacun, aux entrées de leur base, deux cinquièmes ($T_{21}$, $T_{22}$) et deux sixièmes ($T_{23}$, $T_{24}$) commutateurs de courant à transistor qui sont chacun montés par paire à couplage par l'émetteur, travaillent en opposition de phase et sont montés en série sur le chemin du collecteur des quatrièmes commutateurs de courant à transistor ($T_{25}$, $T_{26}$),

par le fait que les collecteurs du premier cinquième ($T_{21}$) et du premier sixième ($T_{23}$) commutateurs de courant et les collecteurs de l'autre cinquième ($T_{22}$) et de l'autre sixième ($T_{24}$) commutateurs de courant sont respectivement connectés ensemble, étant précisé que le premier cinquième ($T_{21}$) et l'autre sixième ($T_{24}$) commutateurs de courant sont pilotés, par l'intermédiaire du transistor à montage émetteur-suiveur respectif, par le signal qui apparaît à la première entrée de l'étage d'entrée à transistor pour le second signal d'entrée ($U_{E2}$) et que l'autre cinquième ($T_{22}$) et le premier sixième ($T_{23}$) commutateurs de courant le sont, par l'intermédiaire du transistor à montage émetteur-suiveur respectif, par le signal qui apparaît à la seconde entrée de l'étage d'entrée à transistor pour le second signal d'entrée ($U_{E2}$),

et par le fait que les deux paires de collecteurs, connectées ensemble, des cinquièmes ($T_{21}$, $T_{22}$) et des sixièmes ($T_{23}$, $T_{24}$) commutateurs de courant sont réunies, avec les deux paires de collecteurs, connectées ensemble, des seconds ($T_{11}$, $T_{12}$) et des troisièmes ($T_{13}$, $T_{14}$) commutateurs de courant de façon telle que les collecteurs du premier second ($T_{11}$), du premier troisième ($T_{13}$), du premier cinquième ($T_{21}$) et du premier sixième ($T_{23}$) commutateurs de courant et le collecteur de l'autre second ($T_{12}$), de l'autre troisième ($T_{14}$), de l'autre cinquième ($T_{22}$) et de l'autre

sixième ($T_{24}$) commutateurs de courant sont respectivement réunis ensemble.

2. Disposition de circuit selon la revendication 1, caractérisée par le fait que les premiers étages de transistor à montage émetteur-suiveur ($EF_1$, $EF_2$; $EF_3$, $EF_4$) des étages d'entrée présentent chacun des résistances ($R_2$) de l'émetteur identiques.

3. Disposition de circuit selon la revendication 1 ou 2, caractérisée par le fait que les seconds étages de transistors à montage émetteur-suiveur ($EF_5$, $EF_6$; $EF_7$, $EF_8$) des étages d'entrée présentent chacun des résistances ($R_3$) de l'émetteur identiques.

4. Disposition de circuit selon la revendication 1, 2 ou 3, caractérisée par le fait que le premier groupe des premier, second et troisième commutateurs de courant et l'autre groupe des quatrième, cinquième et sixième commutateurs de courant sont chacun alimentés par une source de courant d'intensité de courant identique ($I_0/2$).

5. Disposition de circuit selon l'une des revendications précédentes, caractérisée par le fait que sont prévus deux étages de prédistorsion ($T_{17}$, $T_{18}$; $T_{27}$, $T_{28}$) qui sont chacun constitués de deux transistors travaillant en opposition de phase et montés à couplage par l'émetteur, et qui sont insérés entre les sorties des seconds transistors à montage émetteur-suiveur ($EF_5$, $EF_6$; $EF_7$, $EF_8$) des étages d'entrée à transistor pour le premier ($U_{E1}$) ou pour le second ($U_{E2}$) signal d'entrée et les entrées des seconds et des troisièmes ou des cinquièmes et des sixièmes comnutateurs de courant ($T_{11}$, $T_{12}$, $T_{13}$, $T_{14}$; $T_{21}$, $T_{22}$, $T_{23}$, $T_{24}$) et par le fait que, du côté de l'émetteur, dans le cas des transistors des deux étages de prédistorsion ($T_{17}$, $T_{18}$; $T_{27}$, $T_{28}$) et dans le cas des transistors ($T_{15}$, $T_{16}$; $T_{25}$, $T_{26}$) des premiers et des quatrièmes commutateurs de courant sont respectivement insérées des résistances de contre-réaction ($R_5$; $R_6$).

6. Disposition de circuit selon la revendication 5, caractérisée par le fait que les bases des transistors à montage émetteur-suiveur ($EF_1$, $EF_2$, $EF_3$, $EF_4$) des deux étages d'entrée à transistor sont chacune reliées, par l'intermédiaire d'une résistance ($R_4$), avec le premier pôle (masse) de la tension de service.

7. Disposition de circuit selon l'une des revendications 5 ou 6, caractérisée par le fait que les bases des paires de transistors ($T_{17}$, $T_{18}$; $T_{27}$, $T_{28}$) du premier et du second étages de prédistorsion ainsi que les bases des paires de transistors $T_{25}$, $T_{26}$ ;

$T_{15}$, $T_{16}$) des quatrièmes et des premiers commutateurs de courant sont respectivement reliées avec les émetteurs du second étage de transistors à montage émetteur-suiveur ($EF_5$, $EF_6$; $EF_7$, $EF_8$) du premier ou du second étage d'entrée.

8. Disposition de circuit selon l'une des revendications 5 à 7, caractérisée par le fait que les collecteurs des paires de transistors des étages de prédistorsion sont resepctivement reliés, par l'intermédiaire de diodes de découplage ($D_{11}$, $D_{12}$; $D_{21}$, $D_{22}$) et de plus, en série, respectivement par paire, par l'intermédiaire d'une résistance du collecteur commune ($R_7$; $R_7$), avec le premier pôle (masse) de la tension de service.

9. Disposition de circuit selon l'une des revendications 5 à 8, caractérisée par le fait que les deux étages de prédistorsion sont chacun alimentés par une source de courant ($TS_1$, $R_8$).

10. Disposition de circuit selon l'une des revendications 5 à 8, caractérisé par le fait que, du premier étage de prédistorsion, le collecteur du premier transitor ($T_{17}$) est relié avec les bases du premier second ($T_{11}$) et de l'autre troisième ($T_{14}$) commutateurs de courant et le collecteur de l'autre transistor ($T_{18}$), avec les bases de l'autre second ($T_{12}$) et du premier troisième ($T_{13}$) commutateur de courant, par le fait que, du second étage de prédistorsion, le collecteur du premier transistor ($T_{27}$) est relié avec les bases du premier cinquième ($T_{21}$) et de l'autre sixième ($T_{24}$) commutateur de courant et le collecteur de l'autre transistor ($T_{28}$), avec les bases de l'autre cinquième ($T_{22}$) et du premier sixième ($T_{23}$) commutateur de courant.

11. Disposition de circuit selon l'une des revendications précédentes, caractérisée par une réalisation en technique de logique à couplage émetteur-émetteur $E^2CL$.

**Claims**

1. A circuit arrangement for the exclusive OR linkage of two signals, the arrangement including a group of serially arranged current switches fed by a current source which is connected with the one pole of the operating voltage source, the arrangement further including a transistor input stage fed by the operating voltage source for the first input signal ($U_{E1}$) and for the second input signal ($U_{E2}$), with each transistor input stage being provided with a first input and a second input between which the respective input signal ($U_{E1}$; $U_{E2}$) is present and with first emitter followers ($EF_1$, $EF_2$; $EF_3$, $EF_4$) at its two inputs for level matching and decoupling; wherein, in order to shift the level of the second input signal ($U_{E2}$), the outputs of the first emitter followers ($EF_3$; $EF_4$) provided in the transistor input stage for the second input signal ($U_{E2}$) are connected with second emitter followers ($EF_7$; $EF_8$) that are each coupled by way of a diode ($D_3$; $D_4$), with the outputs of the second emitter followers actuating the bases of two first, common-emitter, push-pull transistor current switches ($T_{15}$, $T_{16}$) that are fed by the current source and the outputs of the first emitter followers ($EF_1$; $EF_2$) provided in the transistor input stage for the first input signal ($U_{E1}$) each actuate the bases of two second transistor current switches ($T_{11}$, $T_{12}$) and two third transistor current switches ($T_{13}$, $T_{14}$), each coupled in pairs to have common emitters, operating in push-pull and being serially connected in the collector path of the first transistor switches ($T_{15}$, $T_{16}$), with the collectors of the one second current switch ($T_{11}$) and the one third current switch ($T_{13}$) and the collectors of the other second current switch ($T_{12}$) and the other third current switch ($T_{14}$) being connected together; the one second current switch ($T_{11}$) and the other third current switch ($T_{14}$) are actuated, by way of the respective emitter follower, by the signal at the first input of the transistor input stage for the first input signal ($U_{E1}$); and the other second current switch ($T_{12}$) and the one third current switch ($T_{13}$) are actuated, by way of the respective emitter follower, by the signal at the second input of the transistor input stage for the first input signal ($U_{E1}$); and the two interconnected collector pairs of the second current switches ($T_{11}$, $T_{12}$) and of the third current switches ($T_{13}$, $T_{14}$) are connected, in each case by way of the same size load resistance ($R_1$), with the other pole of the operating voltage source, and the difference output signal ($U_A$) of the circuit arrangement is obtained from the voltage difference between the two interconnected collector pairs,

characterized in that

the first emitter followers ($EF_1$; $EF_2$) provided in the transistor input stage for the first input signal ($U_{E1}$) to shift the level of the first input signal ($U_{E1}$) are each followed by second emitter followers ($EF_5$; $EF_6$) that are coupled together by way of a diode ($D_1$; $D_2$) and whose outputs actuate the bases of two fourth, common-emitter, push-pull transistor current switches ($T_{25}$, $T_{26}$) that are fed by the current source;

the outputs of the first emitter followers ($EF_3$; $EF_4$) provided in the transistor input stage for the second input signal ($U_{E2}$) each actuate the bases of two fifth transistor current switches (($T_{21}$, $T_{22}$) and two sixth transistor current switches ($T_{23}$, $T_{24}$), each coupled in pairs to have common emitters, operating in push-pull, and being serially connected in the collector path of the fourth transistor current switches ($T_{25}$, $T_{26}$) ;

the collectors of the one fifth current switch ($T_{21}$) and of the one sixth current switch ($T_{23}$) and the collectors of the other fifth current switch ($T_{22}$) and the other sixth current switch ($T_{24}$) are connected together, with the one fifth current switch ($T_{21}$) and the other sixth current switch ($T_{24}$) being actuated, by way of the respective emitter follower, by the signal at the first input of the transistor input stage for the second input signal ($U_{E2}$), and the other fifth current switch ($T_{22}$) and the one sixth current switch ($T_{23}$) are actuated, by way of the respective emitter follower, by the signal at the second input of the transistor input stage for the second input signal ($U_{E2}$); and

the two interconnected collector pairs of the fifth current switches ($T_{21}$, $T_{22}$) and the sixth current switches ($T_{23}$, $T_{24}$) are connected with the two interconnected collector pairs of the second current switch ($T_{11}$, $T_{12}$) and the third current switches ($T_{13}$, $T_{14}$) in such a manner that the collectors of the one second ($T_{11}$), third ($T_{13}$), fifth ($T_{21}$) and sixth ($T_{23}$) current switches and the collectors of the other second ($T_{12}$), third ($T_{14}$), fifth ($T_{22}$) and sixth ($T_{24}$) current switches are connected with one another.

2. A circuit arrangement according to Claim 1, characterized in that the first emitter follower stages ($EF_1$, $EF_2$; $EF_3$, $EF_4$) of the input stages each have the same emitter resistance ($R_2$).

3. A circuit arrangement according to Claim 1 or 2, characterized in that the second emitter follower stages ($EF_5$, $EF_6$; $EF_7$, $EF_8$) of the input stages each have the same emitter resistance ($R_3$).

4. A circuit arrangement according to Claim 1, 2 or 3, characterized in that the one group of the first, second and third current switches and the other group of the fourth, fifth and sixth current switches are each fed by a current source having the same current intensity ($I_0/2$).

5. A circuit arrangement according to one of the preceding claims, characterized in that two predistortion stages ($T_{17}$, $T_{18}$; $T_{27}$, $T_{28}$) are provided which are each composed of two push-pull, common emitter transistors and are inserted between the outputs of the second emitter followers ($EF_5$, $EF_6$; $EF_7$, $EF_8$) of the transistor input stages for the first input signal ($U_{E1}$) and the second input signal ($U_{E2}$), respectively; and the inputs of the second and third and fifth and sixth current switches, respectively ($T_{11}$, $T_{12}$, $T_{13}$, $T_{14}$; $T_{21}$, $T_{22}$, $T_{23}$, $T_{24}$); and feedback resistances ($R_5$; $R_6$) are inserted on the emitter sides of the transistors of the two predistortion stages ($T_{17}$, $T_{18}$; $T_{27}$, $T_{28}$) and of the transistors ($T_{15}$, $T_{16}$; $T_{25}$, $T_{26}$) of the first and fourth current switches.

6. A circuit arrangement according to Claim 5, characterized in that the bases of the emitter followers ($EF_1$, $EF_2$, $EF_3$, $EF_4$) of both transistor input stages are each connected via a resistor ($R_4$) with the one pole (ground) of the operating voltage.

7. A circuit arrangement according to either Claim 5 or 6, characterized in that the bases of the transistor pairs ($T_{17}$, $T_{18}$; $T_{27}$, $T_{28}$) of the first and second predistortion stages, as well as the bases of the transistor pairs ($T_{25}$, $T_{26}$; $T_{15}$, $T_{16}$) of the fourth and first current switches are each connected with the emitters of the second emitter follower stage ($EF_5$, $EF_6$; $EF_7$, $EF_8$) of the first and second input stage, respectively.

8. A circuit arrangement according to one of Claims 5 to 7, characterized in that the collectors of the transistor pairs of the predistortion stages are each connected, via decoupling diodes ($D_{11}$, $D_{12}$; $D_{21}$, $D_{22}$) and in series connected pairs via a common collector resistor ($R_7$; $R_7$), with the one pole (ground) of the operating voltage.

9. A circuit arrangement according to one of Claims 5 to 8, characterized in that the two predistortion stages are each fed by a current source ($TS_1$, $R_8$).

10. A circuit arrangement according to one of Claims 5 to 9, characterized in that, in the first predistortion stage, the collector of the one transistor ($T_{17}$) is connected with the bases of the one second current switch ($T_{11}$) and of the other third current switch ($T_{14}$) and the collector of the other transistor ($T_{18}$) is connected with the bases of the other second current switch ($T_{12}$) and the one third current switch ($T_{13}$); in the second predistortion stage, the collector of the one transistor ($T_{27}$) is connected with the bases of the one fifth current switch ($T_{21}$) and the other sixth current switch ($T_{24}$) and the collector of the other transistor ($T_{28}$) is connected with the bases of the other fifth current switch ($T_{22}$) and the one sixth current switch ($T_{23}$).

11. A circuit arrangement according to one of the preceding claims, characterized by its configuration in E$^2$CL technology.

FIG. 1

EP 0 389 577 B1

FIG. 2

FIG. 3